# EUROPEAN PATENT SPECIFICATION

(11) **EP 1 914 843 B1**
(45) Date of publication and mention of the grant of the patent: **08.07.2009**
(21) Application number: 07019627.4
(22) Date of filing: 08.10.2007
(51) Int. Cl.: H01R 13/52

(54) **Electrical junction box**
Elektrischer Verteilerkasten
Boîte de dérivation électrique

(30) Priority: 10.10.2006 JP 2006276333
(43) Date of publication of application: 23.04.2008
(73) Proprietor: YAZAKI CORPORATION, Minato-ku Tokyo, 108-0073 (JP)
(72) Inventor: Nakayama, Makoto, Kakegawa-shi Shizuoka (JP); Kanamaru, Masahiro, Kakegawa-shi Shizuoka (JP)
(74) Representative: HOFFMANN EITLE

(56) References cited:
- DE-A1- 19 903 316
- JP-A- 2001 044 655

## Description

### BACKGROUND OF THE INVENTION

### 1. FIELD OF THE INVENTION

The present invention relates to an electrical junction box having a box body whose both faces are covered with a pair of covers.

### 2. DESCRIPTION OF THE RELATED ART

Conventionally, there is known an electrical junction box having a box body whose lower face is covered with a lower cover and whose upper face is covered with an upper cover, disclosed in Japanese Patent Application Laid-open No. 2001-44655 (see Fig. 1).

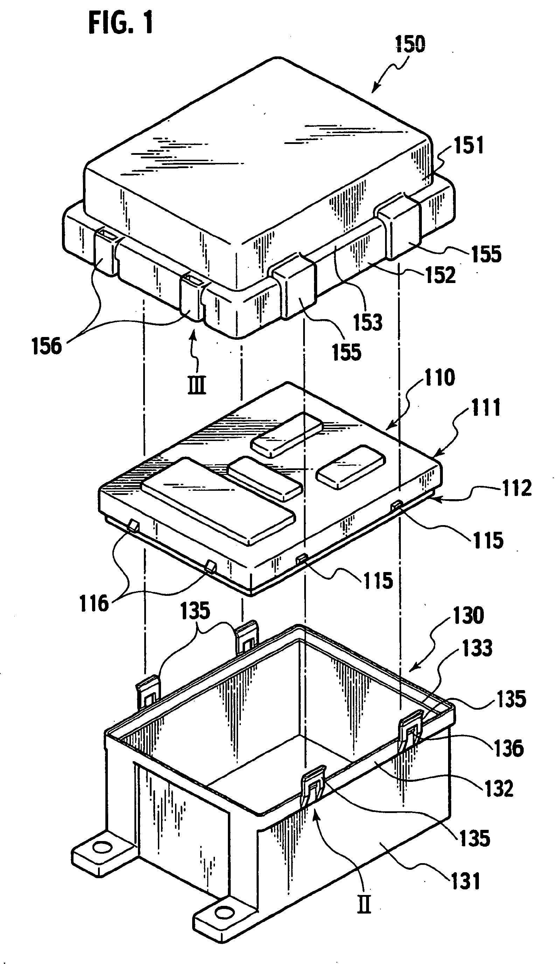

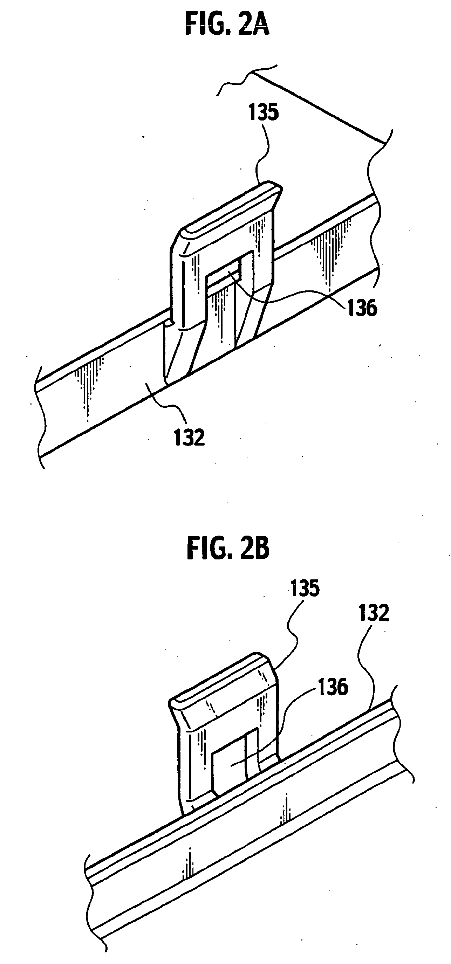

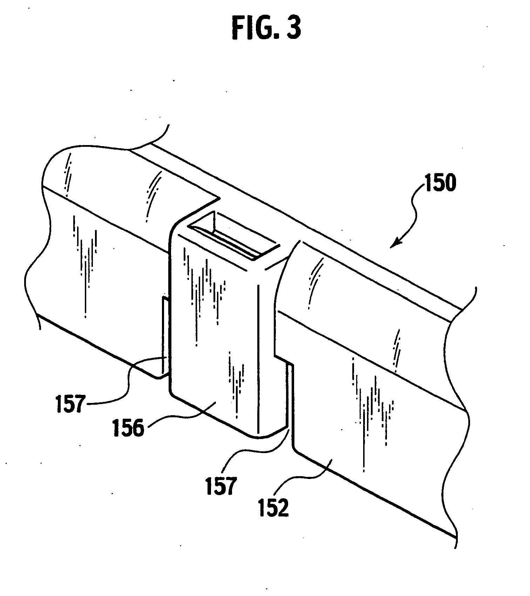

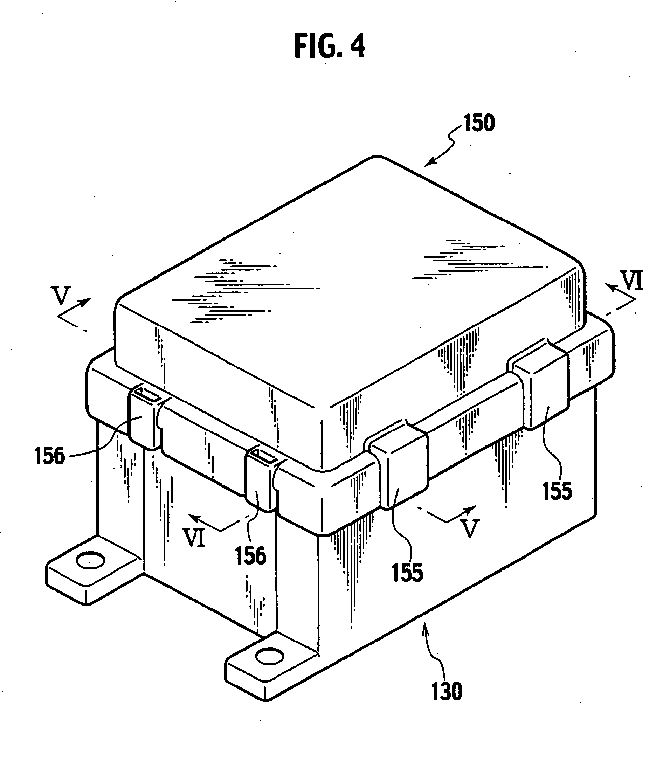

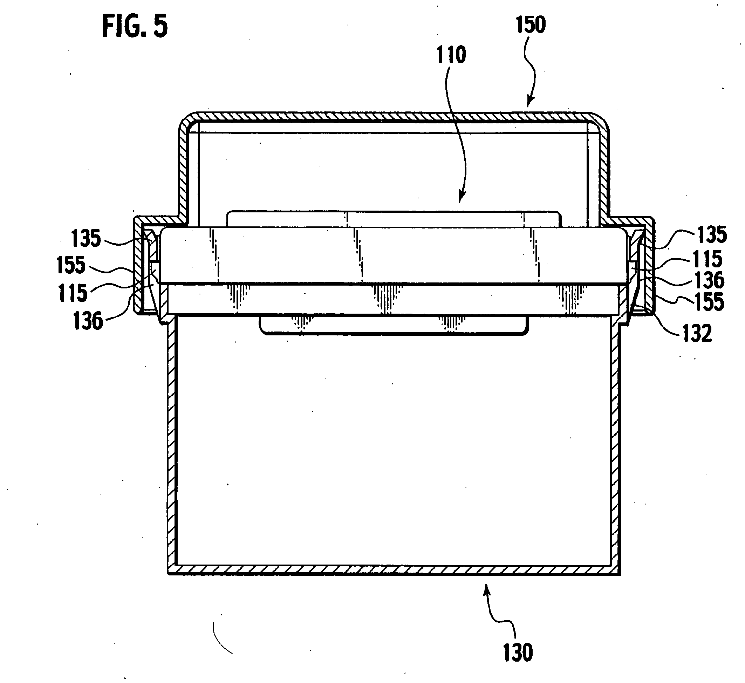

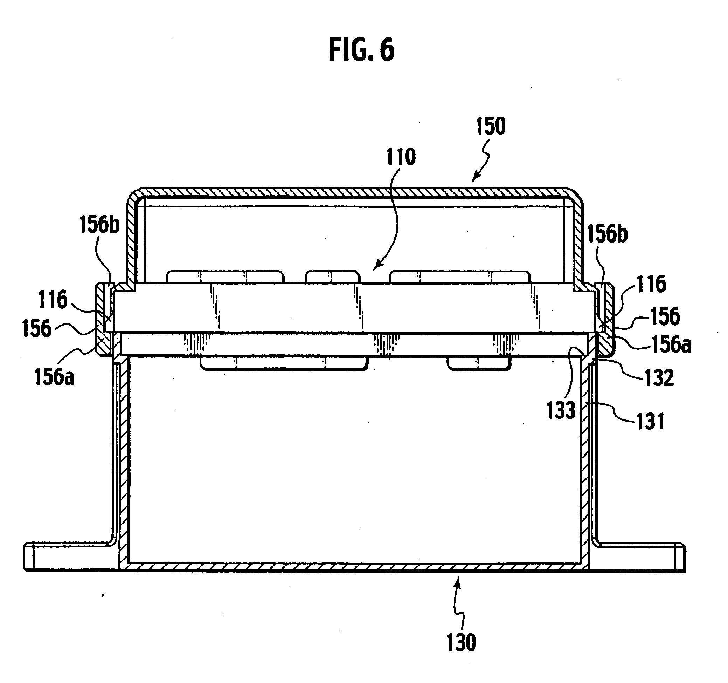

Fig. 1 is an exploded perspective view showing one example of the related electrical junction box. Fig. 2A is an enlarged perspective view of a box part indicated with an arrow II of Fig. 1. Fig. 2B is a perspective view of a box part on the opposite side of Fig. 2A. Fig. 3 is an enlarged perspective view of a box part indicated with an arrow III of Fig. 1. Fig. 4 is an exterior perspective view of the electrical junction box in its assembled state. Fig. 5 is a cross sectional view taken along a line V-V of Fig. 4. Fig. 6 is a cross sectional view taken along a line VI-VI of Fig. 4.

In Fig. 1, the electrical junction box includes a box body 110, a lower cover 130 covering the lower face of the box body 110 and an upper cover 150 covering the upper face of the box body 110.

In the electrical junction box, the box body 110 has an upper casing 111 and a lower casing 112 united with each other and accommodates electrical components in the casings 111, 112. Further, the box body 110 has four engagement projections 115 formed on one pair of opposing sidewalls to engage with the lower cover 130 and four engagement projections 116 formed on the other pair of opposing sidewalls to engage with the upper cover 150.

In the lower cover 130, a top peripheral wall 132 is arranged on the outer circumferential side of a lower peripheral wall 131 and connected to the top of the wall 131 through a step part 133 successively. The step part 133 is formed around a top opening of the lower peripheral wall 131. In the assembled state, the peripheral part of the box body 110 is mounted on the step part 133. As shown in Figs. 2A, 2B and Fig. 5, the top peripheral wall 132 is also provided, on respective outside faces on one pair of opposing sides, with projecting locking pieces 135 having locking holes 136 for engagement with the engagement projections 115 of the box body 110.

The upper cover 150 includes an upper peripheral wall 151 and a lower skirt part 152 arranged on the outer circumferential side of the upper peripheral wall 151 and connected to the lower end of the wall 151 through a step part 153 successively. The step part 153 is formed around a lower opening of the upper peripheral wall 151. In the assembled state, the step part 153 operates to bear down the peripheral part of the box body 110 from above. As shown in Figs. 1 and 6, the lower skirt part 152 is also provided, on its opposing sides, with locking arms 156 having locking projections 156a for engagement with the engagement projections 116 of the box body 110.

For flexibility of the locking arms 156, slits 157 in pairs are formed on both sides of each locking arm 156, as shown in Fig. 3. Inside the locking arms 156, as shown in Fig..6, die-cut holes 156b are defined to mold the locking projections 156a respectively. As shown in Figs. 1, 4 and Fig. 5, locking cover parts 155 are formed on the other opposing sides of the lower skirt part 152 to accommodate the locking pieces 135 of the lower cover 130.

When assembling the electrical junction box, the box body 110 is mounted on the step part 133 of the lower cover 130 to engage the locking projections 115 into the locking holes 136 of the locking pieces 135. In this way, the box body 110 is accommodated and secured in the lower cover 130.

Next, the upper cover 150 is overlaid on the box body 110 to engage the locking arms 156 of the cover 150 with the engagement projections 116 of the box body 110. In this way, the lower cover 130, the box body 110 and the upper cover 150 are fixed with each other integrally.

JP 2001/044655 A discloses a three-parted electrical junction box wherein an upper cover member has a locking piece with one locking part, a lower cover member has a further locking piece with a locking part and a medium cover member has a locking part including one locking piece that comprises a locking part corresponding to the locking part of the upper cover member and another locking part corresponding to the locking part of the lower cover member.

### SUMMARY OF THE INVENTION

In the above-mentioned electrical junction box, there are provided one locking mechanism for locking the box body 110 on the lower cover 130 (i.e. the locking pieces 135, the engagement projections 110) and another locking mechanism for locking the upper cover 150 on the box body 110 (i.e. the locking arms 156, the engagement projections 116), separately. Therefore, the multiplicity of the locking mechanisms causes the electrical junction box to be raised in manufacturing cost.

Additionally, as the above electrical junction box has many places to be unlocked with respect to each maintenance, an operator cannot remove the box body 110 from the lower cover 130 and the upper cover 150 with ease.

Due to the provision of the locking arms 156 on the lower skirt part 152 of the upper cover 150, there is need to arrange the slits 157 for ensuring the flexibility of the arms 156.

Still further, the upper cover 150 has to be provided with the locking cover parts 155 of no concern for locking in order to avoid interference of the upper cover 150 with the locking pieces 135 of the lower cover 130.

Under such a situation about the related art, it is an object of the present invention to provide an electrical junction box which enables its manufacturing cost to be reduced with a simple structure excluding as many extra elements as possible and which can facilitate an operator's maintenance.

In order to attain the above object, an electrical junction box according to the invention comprises the features of claim 1. Preferred embodiments are depicted by the features of the dependent claims.

In an aspect of the present invention, an electrical junction box comprises a box body, an attaching part and a cover both arranged so as to cover both faces of the box body, and a flexible locking piece formed in either the attaching part or the cover, wherein the flexible locking piece has a first locking part configured to lock the box body and a second locking part configured to lock the other of the attaching part and the cover.

According to the aspect of the invention, since the flexible locking piece in the attaching part (or the cover) has the first locking part for locking the box body and the second locking part for locking the cover (or the attaching part) formed together, respective engagement positions of the attaching part and the cover with respect to the box body can be integrated to an identical position. Accordingly, it becomes easy for an operator to check both omission of components in loading the electrical junction box on a vehicle and half engagement between the attaching part and the cover. Additionally, as the number of the flexible locking pieces can be reduced to half, the electrical junction box is simplified in structure to allow its material cost and die cost for moulding to be together reduced, contributing in the reduction of a product cost. Again, since both locking conditions of the flexible locking piece against the cover (or the attaching part) and the box body can be cancelled by an operator's manipulating of the identical locking piece, the number of box's positions to be unlocked in disassembling the electrical junction box can be reduced to facilitate an operator's clearing work of the box body at maintenance.

Further, the flexible locking piece may be formed on a peripheral part of the attaching part so as to project toward the cover in an assembled state thereof, and the flexible locking piece may have a length exceeding a height of the box body locked on the first locking part.

With the above configuration, since the flexible locking piece is established to have a length exceeding the height of the box body in the assembled state, an operator can release the flexible locking piece from the box body through operator's fingers easily without being interfered by the box body.

Further, a bending direction of the flexible locking piece to unlock the first locking part may be opposite to a bending direction of the flexible locking piece to unlock the second locking part.

With the above configuration, the bending direction of the flexible locking piece required to unlock the first locking part is opposite to the bending direction required to unlock the second locking part. For instance, therefore, even if the first locking part is under the half-engagement condition, an operator can be aware of such a situation because the upper cover couldn't be locked on the second locking part. Further, if once the piece were locked on the second locking part, the flexible locking piece couldn't be deflected in the direction to unlock the first locking part. Thus, it is possible to prevent the flexible locking piece from being unlocked improperly.

Further, the cover may be an upper cover covering an upper face of the box body, the attaching part may be a lower cover covering a lower face of the box body, the flexible locking piece may be formed so as to project on a peripheral part of the lower cover, the second locking part may be positioned above the first locking part of the flexible locking piece, and the box body may have an engagement part locked on the first locking part from inside, while the cover may have an engagement part locked on the second locking part from outside.

With the above configuration, as the lower cover is provided with the flexible locking piece which includes the first locking part to be locked, from the inside, by the engagement part of the box body and the second locking part to be locked, from the outside, by the engagement part of the upper cover. Therefore, by firstly locking the box body on the flexible locking piece of the lower cover and successively covering over them with the upper cover, it is possible to lock the box body on the upper and lower covers, accomplishing the assembling of the electrical junction box with ease.

Further, the lower cover may have a step part formed on a peripheral part of a top opening of the lower cover to mount a peripheral part of the box body, the flexible locking piece may be formed on a top peripheral wall of the lower cover standing on an outer circumferential side of the step part to project upward, the upper cover may have a lower skirt part formed on a peripheral part of a lower opening of the upper cover to overlie the top peripheral wall of the lower cover from above, the upper cover may have a locking cover part formed in a part of the lower skirt part to overlie the flexible locking piece, and the locking cover part may be provided, on an inside wall thereof, with an engagement part configured to engage with the second locking part.

With the above configuration, by firstly mounting the box body on the step part of the lower cover and further covering over them by the upper cover., it is possible to allow the upper cover and the lower cover to accommodate the box body completely and stably. Again, since the electrical junction box is assembled in such a manner that the lower skirt part of the upper cover covers over the top peripheral wall of the lower cover, the so-assembled electrical junction box can effect its sufficient shielding capability against water being about to invade the box from above.

Further, the upper cover may have a hole formed in a top wall of the locking cover part, and the hole may be positioned so as to adjoin a tip of the flexible locking piece of the lower cover on condition that the engagement part of the locking cover part is engaged with the second locking part.

With the above configuration, since the hole is positioned in the top wall of the locking cover part so as to adjoin the tip of the flexible locking piece of the lower cover on condition that the engagement part of the locking cover part is engaged with the second locking part, the engagement of the second locking part of the flexible locking piece with the locking cover part can be cancelled easily by an operator's manipulating the flexible locking piece through the hole in the top wall of the locking cover part.

These and other objects and features of the present invention will become more fully apparent from the following description and appended claims taken in conjunction with the accompany drawings.

### BRIEF DESCRIPTION OF THE DRAWINGS

Fig. 1 is an exploded perspective view showing one example of an electrical junction box in related art;
Fig. 2A is an enlarged perspective view of a box part indicated with an arrow II of Fig. 1 and Fig. 2B is a perspective view of a box part on the opposite side of Fig. 2A;
Fig. 3 is an enlarged perspective view of a box part indicated with an arrow III of Fig. 1;
Fig. 4 is an exterior perspective view of the related electrical junction box in its assembled state;
Fig. 5 is a cross sectional view taken along a line V-V of Fig. 4;
Fig. 6 is a cross sectional view taken along a line VI-VI of Fig. 4;
Fig. 7 is an exploded perspective view of an electrical junction box in accordance with an embodiment of the present invention;
Fig. 8A is an enlarged perspective view of a box part indicated with an arrow VIII of Fig. 7 and Fig. 8B is a perspective view of a box part on the opposite side of Fig. 8A;
Fig. 9 is an exterior perspective view of the electrical junction box in its assembled state of the embodiment of the present invention; and
Fig. 10 is a cross sectional view taken along a line X-X of Fig. 9.

### DETAILED DESCRIPTION OF THE EMBODIMENT

Referring to accompanying drawings, an embodiment of the present invention will be described below. In these drawings, identical or similar elements are indicated with same or similar reference numerals, respectively.

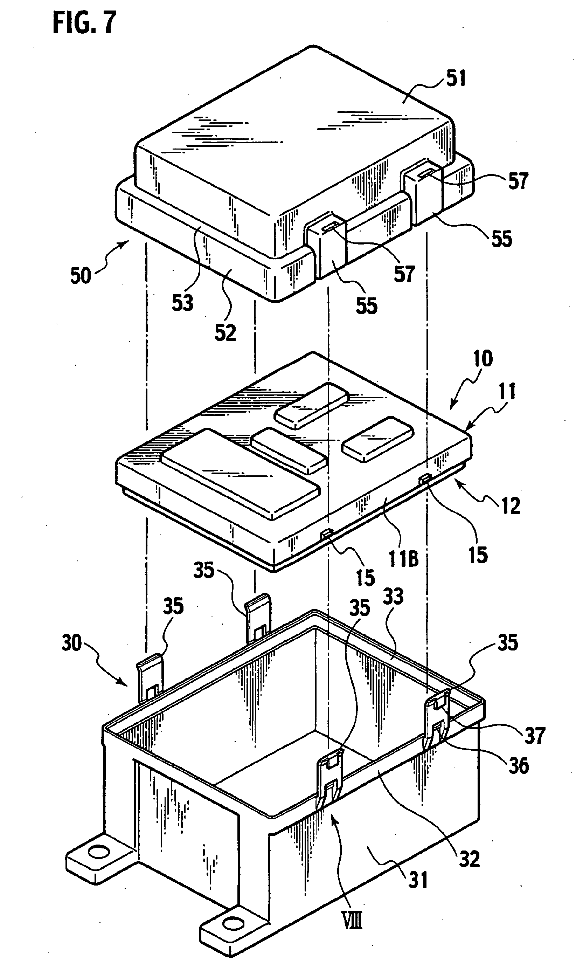

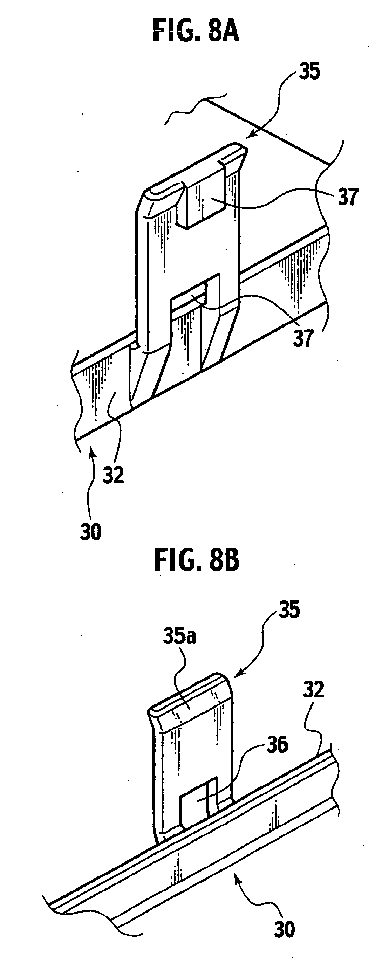

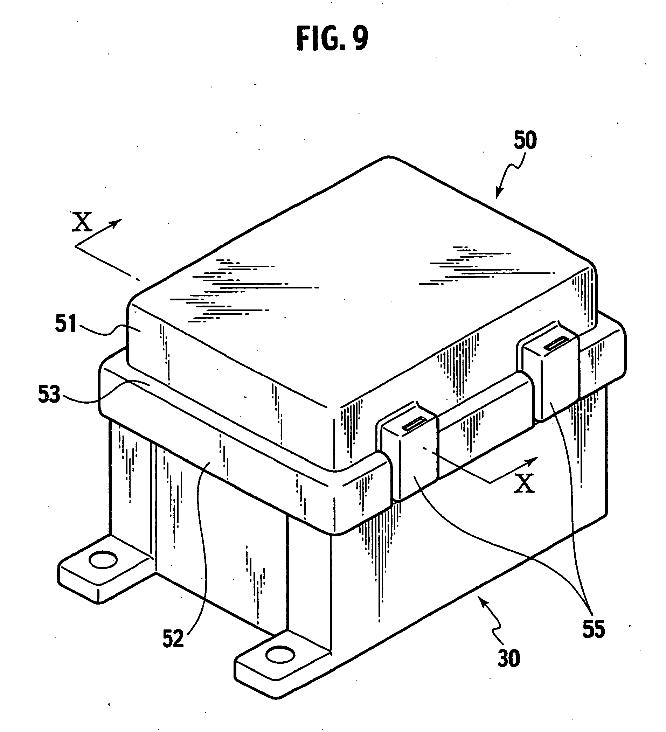

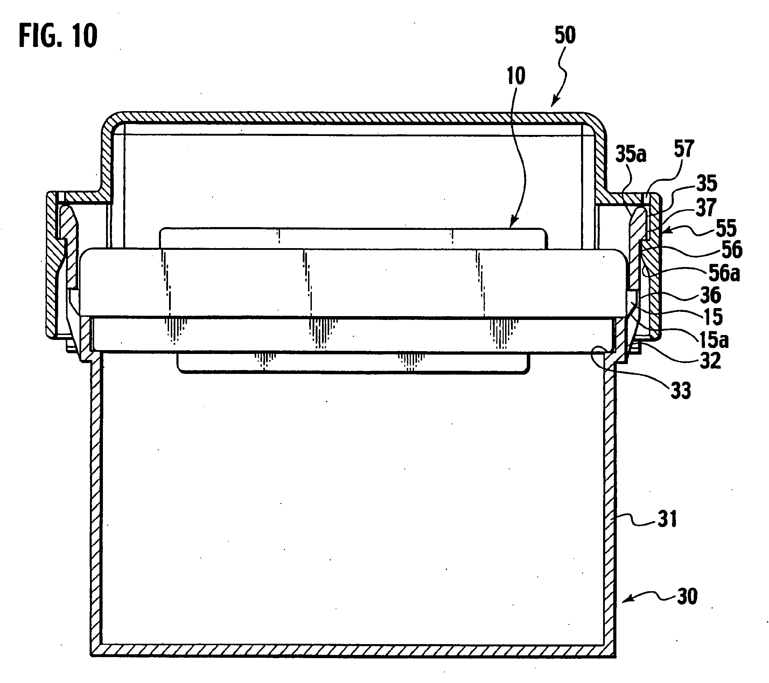

In the drawings, Fig. 7 is an exploded perspective view of an electrical junction box of the embodiment of the present invention. Fig. 8A is an enlarged perspective view of a box part indicated with an arrow VIII of Fig. 7. Fig. 8B is a perspective view of a box part on the opposite side of Fig. 8A. Fig. 9 is an exterior perspective view of the electrical junction box in its assembled state. Fig. 10 is a cross sectional view taken along a line X-X of Fig. 9.

As shown in Fig. 7, the electrical junction box includes a box body 10, a lower cover 30 (i.e. an attaching part of the invention) for covering the lower face of the box body 10 and an upper cover 50 (i.e. a cover of the invention) for covering the upper face of the box body 10.

The box body 10 is formed by an upper casing 11 and a lower casing 12 united with the upper casing 11 and accommodates electrical components in the box body 10. The box body 10 has four engagement projections 15 formed on one pair of opposing outer sidewalls to lock the box body 10 on the lower cover 30. Note, the box body 10 is provided with no engagement projection on the other pair of opposing outer sidewalls.

In the lower cover 30, a top peripheral wall 32 is arranged on the outer circumferential side of a lower peripheral wall 31 and also connected to the top end of the wall 31 through a step part 33 successively. The step part 33 is formed along a peripheral part of the lower cover 30 close to its top opening. In the assembled state, the peripheral part of the box body 10 is mounted on the step part 33. The top peripheral wall 32 has flexible locking pieces 35 formed on respective outside faces on one pair of opposing sides to projecting upwards. Each of the flexible locking pieces 35 has a locking hole 36 (i.e. a first locking part of the invention) for engagement with the engagement projection 15 of the box body 10 and an engagement protrusion 37 (i.e. a second locking part of the invention) for engagement with the upper cover 50.

The flexible locking piece 35 is established to have a length exceeding the height of the box body 10 when it is mounted on the step part 33 and further locked on the flexible locking piece 35. In the flexible locking piece 35, the engagement protrusion 37 is positioned above the locking hole 36.

In the upper cover 50, a lower skirt part 52 is arranged on the outer circumferential side of an upper peripheral wall 51 and also connected to the lower end of the wall 51 through a step part 53 successively. The step part 53 is formed along a peripheral part of the upper cover 50 close to its lower opening. In the assembled state, the step part 53 operates to bear down the peripheral part of the box body 10 from above. Additionally, the upper cover 50 has locking cover parts 55 formed on one pair of opposing sides of the lower skirt part 52 to cover over the flexible locking pieces 35, respectively. As shown in Fig. 10, each of the locking cover parts 55 is provided, on its inside wall, with an engagement projection 56 for engagement with the engagement protrusion (the second locking part) 37 of the flexible locking piece 35.

Then, the locking hole 36 as the first locking part is locked, from its inside, by the engagement projection 15 of the box body 10, while the engagement protrusion 37 as the second locking part is locked, from its outside, by the engagement projections 56 of the upper cover 50. For that purpose, the engagement protrusion 37 is formed on the exterior face of the flexible locking piece 35. Thus, the flexible locking piece 35 is adapted so as to bend outwardly in unlocking the engagement projection 15 from the locking hole 36 and bend inwardly in unlocking the engagement protrusion 37 from the engagement projection 56.

In order to facilitate the mutual engagement between the flexible locking piece 35 and the engagement projection 15, the flexible locking piece 35 is provided, inside its top end, with a slanted face 35a, while the engagement projection 15 is provided, on its lower end face, with a slanted face 15a. Further, the locking cover part 55 has a slanted face 56 formed on the lower end of the engagement projection 56 similarly. The locking cover part 55 has a die-cut hole 57 formed in the top wall to mold the engagement projection 56.

In order to assemble the electrical junction box, the box body 10 is mounted on the step part 33 of the lower cover 30 to engage the engagement projections 15 into the locking holes 36 of the flexible locking pieces 35. In this way, the box body 10 can be accommodated and secured in the lower cover 30.

Next, the upper cover 50 is arranged above the box body 10 so that the locking cover parts 55 cover over the flexible locking pieces 35 respectively. With this operation, the engagement projections 56 on the inside faces of the locking cover parts 55 engage with the engagement protrusions 37 of the locking pieces 35. In this way, the lower cover 30, the box body 10 and the upper cover 50 are fixed with each other integrally.

In order to disassemble the electrical junction box, upon disengaging the flexible locking pieces 35 from the engagement projections 56 by firstly inserting the tip of an appropriate tool (e.g. screwdriver) into each die-cut hole 57 of the locking cover parts 55 and further bending the flexible locking pieces 55 inwardly, the upper cover 50 is detached from the lower cover 30. Next, each of the engagement projections 15 is disengaged from the locking hole 36 by an operator finger's hooking on the top end of the flexible locking piece 35 and successively bending it to the outside. In this state, by an operator's lifting up the box body 10, it is detached from the lower cover 30.

Then, since each flexible locking piece 35 is established to have a length exceeding the height of the box body 10 in the assembled state, an operator can operate to unlock the flexible locking pieces 35 with operator's fingers easily without being interfered by the box body 10.

According to the electrical junction box of this embodiment, since the locking hole 36 as the first locking part for locking the box body 10 and the engagement protrusion 37 as the second locking part for locking the upper cover 50 are together formed in each flexible locking piece 35 of the lower cover 30, respective engagement positions of the covers 30, 50 with respect to the box body 10 can be integrated to an identical position (about each locking piece 35). Accordingly, it becomes easy for an operator to check both omission of components in loading the electrical junction box on a vehicle (not shown) and "half engagement" (i.e. incomplete fitting) between the upper cover 50 and the lower cover 30.

Additionally, as the number of the flexible locking pieces 35 can be reduced to half, the electrical junction box is simplified in structure to allow its material cost and die cost for molding to be together reduced, contributing in the reduction of a product cost. Again, since both locking conditions of one flexible locking piece 35 against the upper cover 50 and the box body 10 can be cancelled by an operator's manipulating of the identical locking piece 35, the number of box's positions to be unlocked in disassembling the electrical junction box can be reduced in comparison with that of the electrical junction box in related art, facilitating an operator's clearing work of the box body 10 at maintenance.

Additionally, it is noted that the bending direction of each flexible locking piece 35 required to unlock the relevant locking hole 36 is opposite to the bending direction required to unlock the relevant engagement protrusion 37. For instance, therefore, even if the locking hole 36 is under the half-engagement condition, an operator can be aware of such a situation because the upper cover 50 couldn't be locked on the engagement protrusion 37. Further, if once the piece 35 were locked on the engagement protrusion 37, the flexible locking piece 35 couldn't be deflected in the direction to unlock the locking hole 36. Thus, it is possible to prevent the flexible locking piece 35 from being unlocked improperly.

Again, the lower cover 30 is provided with the flexible locking pieces 35 each of which includes the locking hole 36 to be locked, from the inside, by the engagement projection 15 of the box body 10 and the engagement protrusion 37 to be locked, from the outside, by the engagement projection 56 of the upper cover 50. Therefore, by firstly locking the box body 10 on the flexible locking pieces 35 of the lower cover 30 and successively covering over them with the upper cover 50, it is possible to lock the box body 10 on the upper and lower covers 50, 30, accomplishing the assembling of the electrical junction box with ease.

Further, by firstly mounting the box body 10 on the step part 33 of the lower cover 30 and further covering over them with the upper cover 50, it is possible to allow the upper cover 50 and the lower cover 30 to accommodate the box body 10 completely and stably. Again, since the electrical junction box is assembled in such a manner that the lower skirt part 52 of the upper cover 50 covers over the lower peripheral wall 31 or the top peripheral wall 32 of the lower cover 30, the so-assembled electrical junction box can effect its sufficient shielding capability against water being about to invade the box from above.

Still further, since each of the die-cut holes 57 is positioned in the top wall of the locking cover part 55 so as to adjoin the tip of the flexible locking piece 35 of the lower cover 30 on condition that the engagement projection 56 of the locking cover part 55 is engaged with the engagement protrusion 37 of the piece 35, the engagement of the engagement protrusion 37 of the piece 35 with the locking cover part 55 can be cancelled easily by an operator's manipulating the piece 55 through the die-cut hole 55.

Although the flexible locking pieces 35 are formed in the lower cover 30 as one attaching part in the above-mentioned embodiment, the same locking pieces may be formed in the upper cover 50 as one cover instead.

The present invention is therefore to be considered in all respects as illustrative and not restrictive, the scope of the invention being indicated by the appended claims rather than by the foregoing description and all changes which came within the meaning and range of equivalency of the claims are therefore intended to be embraced therein.

## Claims

1. An electrical junction box comprising:
a box body (10);
an attaching part (30) and a cover (50) both arranged so as to cover both faces of the box body (10);
**characterized by** a flexible locking piece (35) formed in either the attaching part (30) or the cover (50),
wherein the flexible locking piece (35) has a first locking part (36) configured to lock the box body (10) and a second locking part (37) configured to lock the other of the attaching part (30) and the cover (50).

2. The electrical junction box of claim 1, wherein
the flexible locking piece (35) is formed on a peripheral part of the attaching part (30) so as to project toward the cover (50) in an assembled state thereof, and
the flexible locking piece (35) has a length exceeding a height of the box body (10) locked on the first locking part (37).

3. The electrical junction box of claim 2, wherein
a bending direction of the flexible locking piece (35) to unlock the first locking part (36) is opposite to a bending direction of the flexible locking piece (35) to unlock the second locking part (37).

4. The electrical junction box of any of claims 1 to 3, wherein
the cover (50) is an upper cover covering an upper face of the box body (10),
the attaching part (30) is a lower cover covering a lower face of the box body (10),
the flexible locking piece (35) is formed so as to project on a peripheral part of the lower cover (31),
the second locking part (37) is positioned above the first locking part (36) of the flexible locking piece (35), and
the box body (10) has an engagement part locked on the first locking part (36) from inside, while the cover has an engagement part locked on the second locking part (37) from outside.

5. The electrical junction box of claim 4, wherein
the lower cover (30) has a step part formed on a peripheral part of a top opening of the lower cover (30) to mount a peripheral part of the box body (10),
the flexible locking piece (35) is formed on a top peripheral wall of the lower cover (30) standing on an outer circumferential side of the step part to project upward,
the upper cover (50) has a lower skirt part formed on a peripheral part of a lower opening of the upper cover (50) to overlie the top peripheral wall of the lower cover from above,
the upper cover (50) has a locking cover part formed in a part of the lower skirt part to overlie the flexible locking piece (35), and
the locking cover part is provided, on an inside wall thereof, with an engagement part configured to engage with the second locking part.

6. The electrical junction box of claim 5, wherein
the upper cover (50) has a hole (36) formed in a top wall of the locking cover part, and
the hole (36) is positioned so as to adjoin a tip of the flexible locking piece (35) of the lower cover (30) on condition that the engagement part of the locking cover part is engaged with the second locking part.

7. The electrical junction box of claim 1, wherein the attaching part (30) and the cover (50) are arranged so as to cover at least all faces of the box body (10) other than a part of the box body (10) engaged to the first locking part (36).

## Patentansprüche

1. Elektrischer Anschlusskasten, umfassend:
einen Kastenkörper (10);
ein Befestigungsteil (30) und eine Abdeckung (50) die beide derart angeordnet sind, dass sie beide Flächen des Kastenkörpers (10) abdecken;
**gekennzeichnet durch**
ein flexibles Sperrstück (35), das entweder an dem Befestigungsteil (30) oder der Abdeckung (30) ausgebildet ist,
bei dem das flexible Sperrstück (35) ein erstes Sperrteil (36), das so aufgebaut ist, dass er den Kastenkörper (10) sperrt, und ein zweites Sperrteil (37) aufweist, das so aufgebaut ist, dass es den anderen des Befestigungsteils (30) oder der Abdeckung (50) sperrt.

2. Elektrischer Anschlusskasten nach Anspruch 1, bei dem
das flexible Sperrstück (35) so an einem Umfangsteil des Befestigungsteils (30) ausgebildet ist, dass es in seinem zusammengebauten Zustand entgegen der Abdeckung (50) hervorsteht, und
das flexible Sperrstück (35) eine Länge aufweist, die eine Höhe des Kastenkörpers (10), der an dem ersten Sperrteil (36) eingerastet ist, überschreitet.

3. Elektrischer Anschlusskasten nach Anspruch 2, bei dem
eine Biegerichtung des flexiblen Sperrstücks (35) zum Entsperren des ersten Sperrteils (36) zu einer Biegerichtung des flexiblen Sperrstücks (35) zum Entsperren des zweiten Sperrteils (36) entgegengesetzt ist.

4. Elektrischer Anschlusskasten nach einem der Ansprüche 1 bis 3, bei dem
die Abdeckung (50) eine obere Abdeckung ist, die die obere Fläche des Kastenkörpers (10) abdeckt,
das Befestigungsteil (30) eine untere Abdeckung ist, die eine untere Fläche des Kastenkörpers (10) abdeckt,
das flexible Sperrstück (35) derart ausgebildet ist, das es an einem Umfangsteil der unteren Abdeckung (31) hervorsteht,
das zweite Sperrteil (37) über dem ersten Sperrteil (36) des flexiblen Sperrstücks (35) positioniert ist, und
der Kastenkörper (10) einen Eingriffsteil aufweist, der von der Innenseite an dem ersten Sperrteil (36) gesperrt ist, während die Abdeckung einen Eingriffsteil aufweist, der von der Außenseite an dem zweiten Sperrteil (37) gesperrt ist.

5. Elektrischer Anschlusskasten nach Anspruch 4, bei dem
die untere Abdeckung (30) einen Stufenteil aufweist, der an einem Umfangsteil einer oberen Öffnung der unteren Abdeckung (30) ausgebildet ist, so dass er einen Umfangsteil des Kastenkörpers (10) befestigt,
das flexible Sperrstück (35) an einer oberen Umfangswand der unteren Abdeckung (30) ausgebildet ist, die so an einer äußeren umlaufenden Seite des Stufenteils steht, dass sie nach oben hervorsteht,
die obere Abdeckung (50) einen unteren Schürzenbereich aufweist, der an einem Umfangsteil einer unteren Öffnung der oberen Abdeckung (50) ausgebildet ist, um die obere Umfangswand der unteren Abdeckung von oben zu überlagern,
die obere Abdeckung (50) ein Sperrabdeckungsteil so in einem Teil des unteren Schürzenbereichs aufweist, dass das flexible Sperrstück (35) überlagert ist, und
das Sperrabdeckungsteil an seiner Innenseite mit einem Eingriffsteil versehen ist, der derart eingerichtet ist, dass er mit dem zweiten Sperrteil eingreift.

6. Elektrischer Anschlusskasten nach Anspruch 5, bei dem
die obere Abdeckung (50) ein Loch (36) aufweist, das in eine obere Wand des Sperrabdeckungsteils ausgebildet ist, und
das Loch (36) so positioniert ist, das es an eine Spitze des flexiblen Sperrstücks (35) der unteren Abdeckung (30) unter der Bedingung angrenzt, dass der Eingriffsteil des Sperrabdeckungsteils mit dem zweiten Sperrteil eingreift.

7. Elektrischer Anschlusskasten nach Anspruch 1, bei dem
das Befestigungsteil (30) und die Abdeckung (50) derart angeordnet sind, dass sie zumindest alle anderen Flächen des Kastenkörpers (10) abdecken, als den Teil des Kastenkörpers (10), der mit dem ersten Sperrteil (36) eingreift.

## Revendications

1. Boîte de jonction électrique comprenant:
un corps de boîte (10);
une partie de fixation (30) et un couvercle (50), tous deux agencés de sorte à couvrir les deux faces du corps de boîte (10);
**caractérisée par** une pièce de verrouillage flexible (35) formée soit dans la partie de fixation (30) ou dans le couvercle (50),
où la pièce de verrouillage flexible (35) a une première partie de verrouillage (36) configurée de manière à verrouiller le corps de boîte (10) et une deuxième partie de verrouillage (37) configurée de manière à verrouiller l'autre de la partie de fixation (30) et du couvercle (50).

2. Boîte de jonction électrique de la revendication 1, dans laquelle
la pièce de verrouillage flexible (35) est formée sur une partie périphérique de la partie de fixation (30) de sorte à se projeter vers le couvercle (50) dans son état assemblé, et
la pièce de verrouillage flexible (35) a une longueur dépassant une hauteur du corps de boîte (10) verrouillé sur la première partie de verrouillage (37).

3. Boîte de jonction électrique de la revendication 2, dans laquelle
une direction de flexion de la pièce de verrouillage flexible (35) pour déverrouiller la première partie de verrouillage (36) est opposée à une direction de flexion de la pièce de verrouillage flexible (35) pour déverrouiller la deuxième partie de verrouillage (37).

4. Boîte de jonction électrique de l'une des revendications 1 à 3, dans laquelle
le couvercle (50) est un couvercle supérieur couvrant une face supérieure du corps de boîte (10),
la partie de fixation (30) est un couvercle inférieur couvrant une face inférieure du corps de boîte (10),
la pièce de verrouillage flexible (35) est formée de sorte à se projeter sur une partie périphérique du couvercle inférieur (31),
la deuxième partie de verrouillage (37) est positionnée au-dessus de la première partie de verrouillage (36) de la pièce de verrouillage flexible (35), et
le corps de boîte (10) a une partie d'engagement verrouillée sur la première partie de verrouillage (36) de l'intérieur, tandis que le couvercle a une partie d'engagement verrouillée sur la deuxième partie de verrouillage (37) de l'extérieur.

5. Boîte de jonction électrique de la revendication 4, dans laquelle
le couvercle inférieur (30) a une partie étagée formée sur une partie périphérique d'une ouverture supérieure du couvercle inférieur (30) pour monter une partie périphérique du corps de boîte (10),
la pièce de verrouillage flexible (35) est formée sur une paroi périphérique supérieure du couvercle inférieur (30) s'élevant sur un côté circonférentiel externe de la partie étagée pour se projeter vers le haut.
le couvercle supérieur (50) a une partie de jupe inférieure formée sur une partie périphérique d'une ouverture inférieure du couvercle supérieur (50) pour recouvrir la paroi périphérique supérieure du couvercle inférieur du dessus,
le couvercle supérieur (50) a une partie de couvercle de verrouillage formée dans une partie de la partie de jupe inférieure pour recouvrir la pièce de verrouillage flexible (35), et
la partie du couvercle de verrouillage est dotée, sur une paroi interne correspondante, d'une partie d'engagement configurée de manière à s'engager avec la deuxième partie de verrouillage.

6. Boîte de jonction électrique de la revendication 5, dans laquelle
le couvercle supérieur (50) a un trou (36) formé dans une paroi supérieure de la partie du couvercle de verrouillage, et
le trou (36) est positionné de sorte à toucher un bout de la pièce de verrouillage flexible (35) du couvercle inférieur (30) à condition que la partie d'engagement de la partie du couvercle de verrouillage soit engagée avec la deuxième partie de verrouillage.

7. Boîte de jonction électrique de la revendication 1, dans laquelle la partie de fixation (30) et le couvercle (50) sont agencés de sorte à couvrir au moins toutes les faces du corps de boîte (10) autres qu'une partie du corps de boîte (10) engagée à la première partie de verrouillage (36).
